# EUROPEAN PATENT APPLICATION

(11) **EP 1 930 940 A1**
(43) Date of publication of application: **11.06.2008**
(21) Application number: 06783033.1
(22) Date of filing: 25.08.2006
(51) Int. Cl.: H01L 21/336, H01L 21/312, H01L 29/786, H01L 51/05, H01L 51/30, H01L 51/40

(54) **ORGANIC THIN FILM TRANSISTOR, AND METHOD FOR SURFACE MODIFICATION OF GATE INSULATING LAYER IN ORGANIC THIN FILM TRANSISTOR**

(30) Priority: 31.08.2005 JP 2005252256
(71) Applicant: Riken, Wako-shi, Saitama 351-0198 (JP)
(72) Inventor: TSUKAGOSHI, Kazuhito c/o Riken, Saitama , 351-0198 (JP); SHIGETO, Kunji c/o Riken, Saitama, 351-0198 (JP); YAGI, Iwao c/o Riken, Saitama, 351-0198 (JP); AOYAGI, Yoshinobu c/o Riken, Saitama, 351-0198 (JP)
(74) Representative: Grünecker, Kinkeldey, Stockmair & Schwanhäusser Anwaltssozietät
(86) International application number: PCT/JP2006/316687
(87) International publication number: WO 2007/026608

(57) **Abstract**

This invention provides an organic thin film transistor, which can realize the modification of the surface of a gate insulating layer not only the case where the gate insulating layer is formed of an oxide, but also the case where the gate insulating layer is formed of a material other than the oxide and consequently can significantly improve transistor characteristics, and a method for surface modification of a gate insulating layer in the organic thin film transistor. In an organic thin film transistor comprising a gate insulating layer, an organic semiconductor layer stacked on the gate insulating layer, and an electrode provided on the organic semiconductor layer, a polyparaxylylene layer formed of a continuous polyparaxylylene film is formed on the surface of the gate insulating layer, between the gate insulating layer and the organic semiconductor layer, so as to face and contact with the organic semiconductor layer.

## Description

### Technical Field

The present invention relates to an organic thin film transistor and a method for surface modification of a gate insulating layer in the organic thin film transistor.

### Background Art

Generally, there is known an organic thin film transistor using an organic substance as a material, and such an organic thin film transistor uses an oxide, for example, as a gate insulating layer.
Then, in the organic thin film transistor using an oxide as the gate insulating layer, various methods of performing surface modification of the gate insulating layer formed of an oxide have been proposed to improve its transistor characteristics.
Conventionally, as a method of performing surface modification of the gate insulating layer formed of the oxide, a method of forming a self-assembled film such as octadecyltrichlorosilane (OTS) and 1,1,1,3,3,3-hexamethyldisilazane (HMDS), for example, has been mentioned. Meanwhile, refer to Non-patent Documents 1 to 4 for the method concerning OTS, and refer to Non-patent Document 5 for the method concerning HMDS.

However, the above-described conventional method was limited to the case where the gate insulating layer is formed of an oxide, had a problems that it could not be applied to the case where the gate insulating layer was formed of a substance other than the oxide.

Further, as a patent document related to the organic thin film transistor, there is Japanese Patent Laid-open No.2003-255857 presented as Patent Document 1, for example.

Non-patent Document 1 : D.J.Gundlach, J.A.Nichols, L.Zhou and T.N.Jackson, Appl.Phys.Lett.80, 2925(2002)
Non-patent Document 2 : M.Shtein, J.Mapel, J.B.Benziger and S.Forrest, Appl.Phys.Lett.81, 263(2002)
Non-patent Document 3 : D.Knipp, R.A.Street, A.Volkel and J.Ho, J.Appl.Phys.93, 347(2003)
Non-patent Document 4 : J.Lee, K. Kim, J.H.Kim, S. Im and D. Jung, Appl.Phys.Lett.82, 4169(2003)
Non-patent Document 5 : I.Yagi, K.Tsukagoshi, Y.Aoagi, Appl.Phys.Lett.86, 103502(2005)
Patent Document 1 : Japanese Patent Laid-open No.2003-255857

### Disclosure of the Invention

### Problems to be Solved by the Invention

The present invention has been created in view of the above-described problem that prior art has, and it is an object of the invention to provide an organic thin film transistor and a method for surface modification of the gate insulating layer of the organic thin film transistor, which is capable of modifying the surface of the gate insulating layer not only in the case where the gate insulating layer is formed of an oxide but also in the case where the gate insulating layer is formed of a substance other than the oxide, and consequently transistor characteristics can be significantly improved.

### Means for Solving the Problems

To achieve the above-described objects, the present invention is designed that a layer formed of polyparaxylylene (poly para-xylylene) is formed on the surface of the gate insulating layer.
The formation of polyparaxylylene layer on the surface of the gate insulating layer should only be performed by depositing polyparaxylylene film on the surface of the gate insulating layer by using a chemical vapor deposition (CVD), for example.
Herein, it is preferable that polyparaxylylene have high purity, that is, the purity of 99% or higher, and polychloroparaxylylene whose purity exceeds 99% can be used, for example.
According to the present invention, by the polyparaxylylene layer that is formed on the surface of the gate insulating layer formed of an oxide or a substance other than the oxide, the surface of the gate insulating layer is modified to hydrophobic, a threshold voltage becomes negative, Off can be taken when a gate voltage is zero, and stable operation can be obtained as a transistor.

Specifically, the present invention is an organic thin film transistor where an organic semiconductor layer is stacked on a gate insulating layer and an electrode is formed on the organic semiconductor layer, in which a polyparaxylylene layer formed of a continuous polyparaxylylene film is formed on the surface of the gate insulating layer, between the gate insulating layer and the organic semiconductor layer, so as to face and contact the organic semiconductor layer.
Further, the present invention, in the above-described invention is designed that the polyparaxylylene film is a continuous film whose film thickness shows the angle of 85 degrees or more by contact angle measurement of water.
Further, the present invention, in the above-described invention is designed that the polyparaxylylene has the purity of 99% or higher.
Further, the present invention, in the above-described invention is designed that the thickness of the polyparaxylylene film is 5 to 200nm.
Further, the present invention, in the above-described invention is designed that the polyparaxylylene is polychloroparaxylylene.
Further, the present invention, in the method for surface modification of the gate insulating layer in the organic thin film transistor where the organic semiconductor layer is stacked on the gate insulating layer and the electrode is formed on the organic semiconductor layer is designed that the polyparaxylylene film is deposited on the surface of the gate insulating layer as continuous film having a predetermined thickness by chemical vapor deposition.
Further, the present invention, in the above-described invention is designed that the film thickness of the continuous film shows the angle of 85 degrees or more by the contact angle evaluation of water.
Further, the present invention, in the above-described invention is designed that the polyparaxylylene has the purity of 99% or higher.
Further, the present invention, in the above-described invention is designed that the film thickness of the continuous film is 5 to 200nm.
Further, the present invention, the above-described invention is designed that the polyparaxylylene is polychloroparaxylylene.

### Effect of the Invention

Since the present invention is constituted as described above, the invention exerts an excellent effect that it can perform modification of the surface of the gate insulating layer not only in the case where the gate insulating layer is formed of an oxide but also in the case where the gate insulating layer is formed of a substance other than the oxide, and consequently transistor characteristics can be significantly improved.

### Brief Description of the Drawings

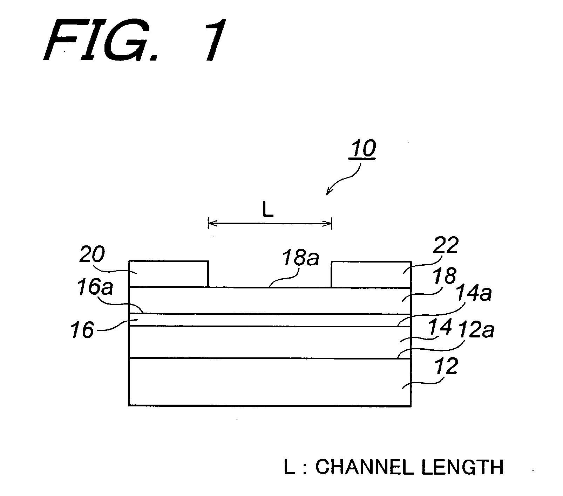

[Figure 1] Fig.1 is a constitution explanatory view showing an example of an embodiment of the organic thin film transistor according to the present invention.

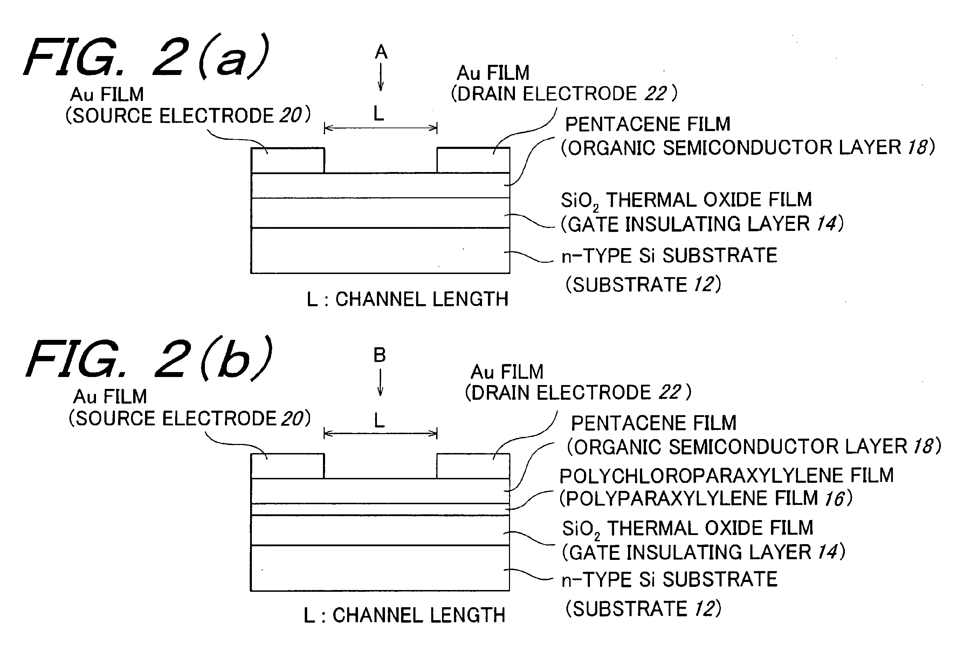

[Figure2] Figs.2(a)(b) respectively show an organic thin film transistor by prior art and the organic thin film transistor by the present invention, in which Fig.2(a) is a constitution explanatory view of the organic thin film transistor by prior art, and Fig.2(b) is a constitution explanatory view of the organic thin film transistor by the present invention.

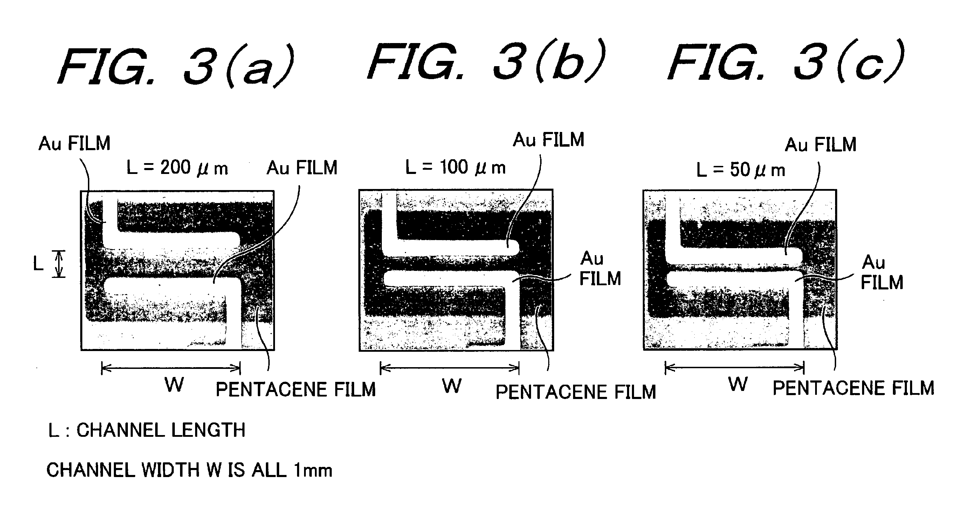

[Figure 3] Figs.3(a) (b) (c) are explanatory views showing the state where the film observed by an optical microscope in arrow A of Fig.2 (a) and in arrow B of Fig.2(b), where Fig. 3 (a) shows the case where a channel length L is 200µm, Fig. 3 (b) shows the case where the channel length L is 100µm, and Fig.3 (c) shows the case where the channel length L is 50µm.

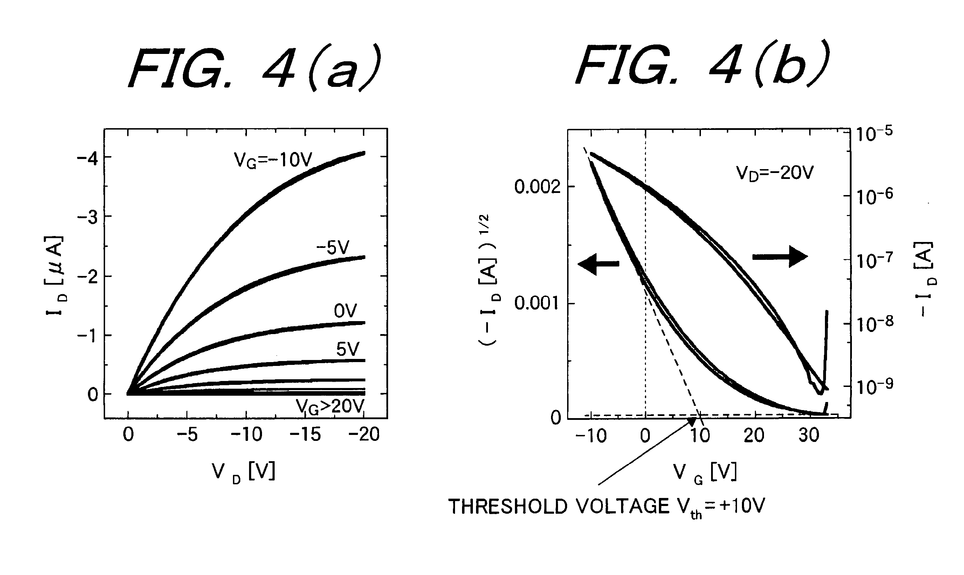

[Figure 4] Figs.4(a)(b) are graphs showing experiment results by the present inventor using the organic thin film transistor having the channel length L of 50µm by prior art, where Fig. 4 (a) is a graph showing the measurement result of the output characteristics of the transistor and Fig.4 (b) is a graph showing the measurement result of the transfer characteristics of the transistor.

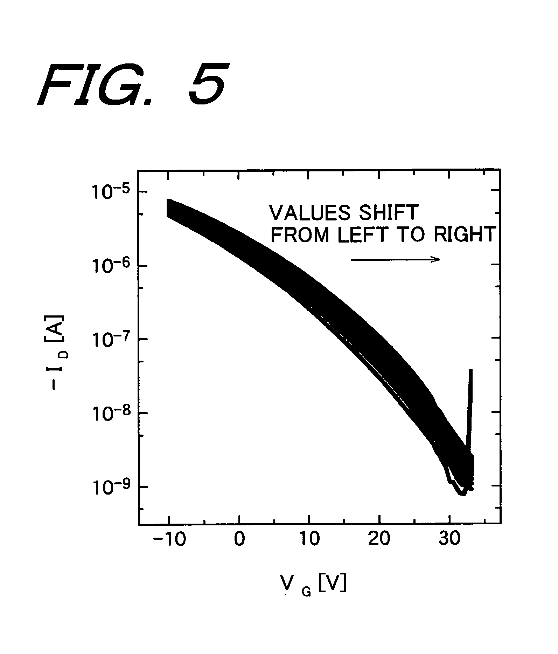

[Figure 5] Fig.5 is a graph showing an experiment result by the present inventor using the organic thin film transistor having the channel length L of 50µm by prior art, where 10 times of measurement were recorded.

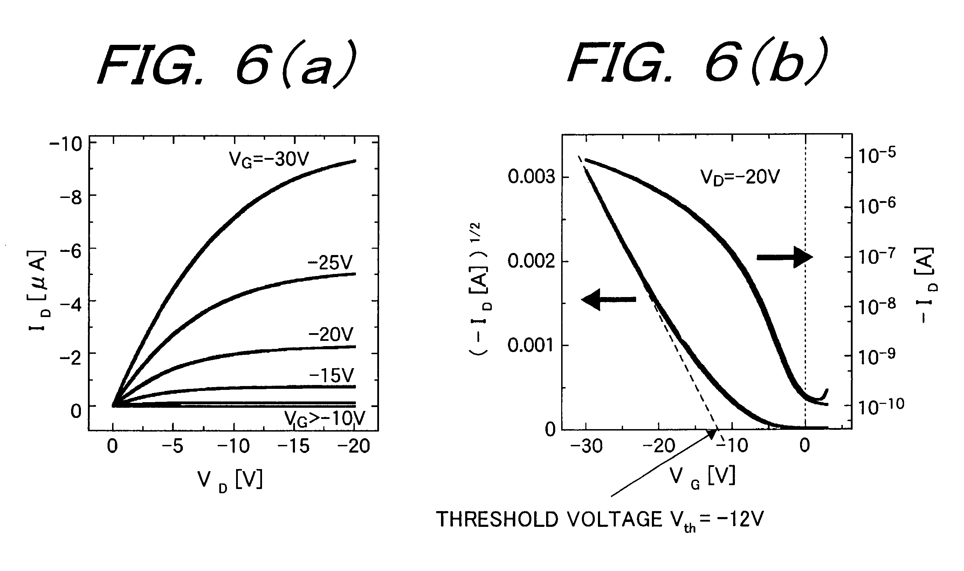

[Figure 6] Figs.6(a)(b) are graphs showing experiment results by the present inventor using the organic thin film transistor having the channel length L of 50µm by the present invention, where Fig.6(a) is a graph showing the measurement result of the output characteristics of the transistor, and Fig.6(b) is a graph showing the measurement result of the transfer characteristics of the transistor.

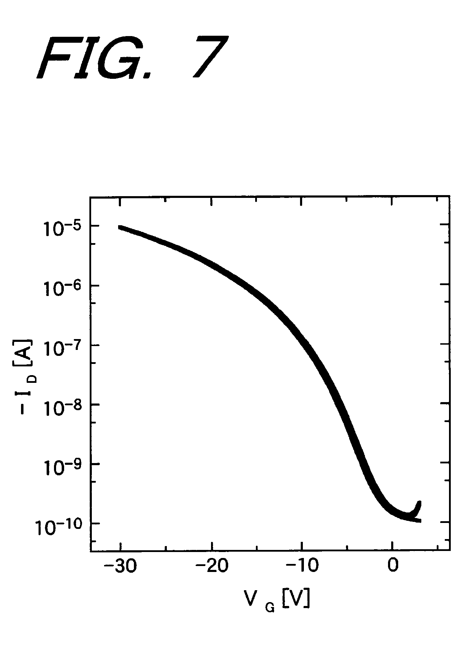

[Figure 7] Fig.7 is a graph showing an experiment result by the present inventor using the organic thin film transistor having the channel length L of 50µm by the present invention, where 10 times of measurement were recorded.

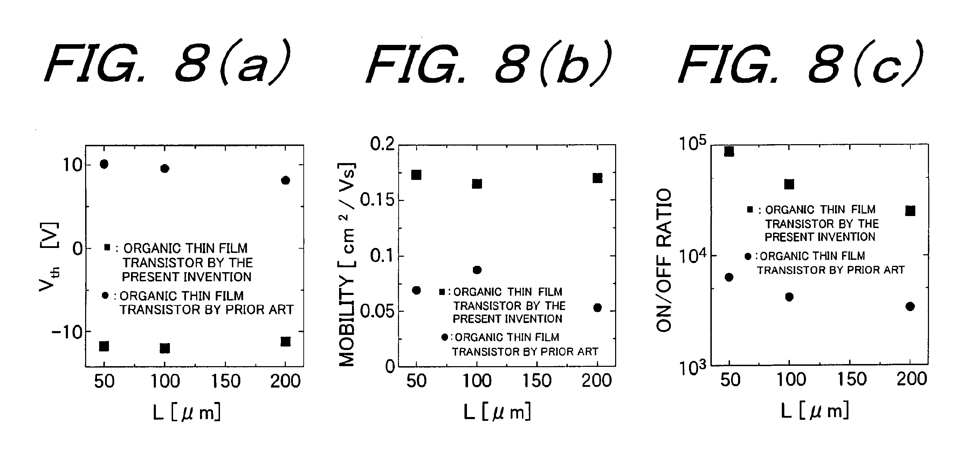

[Figure 8] Figs.8(a)(b)(c) are graphs showing experiment results where the channel length dependency of a threshold voltage Vₜₕ, mobility and on/off ratio regarding the organic thin film transistor by prior art and the organic thin film transistor by the present invention each having the channel length L of 50 µm, 100 µm and 200 µm were measured, where Fig. 8 (a) is a graph showing the channel length dependency of the threshold voltage Vₜₕ, Fig.8(b) is a graph showing the channel length dependency of mobility, Fig.8(c) is a graph showing the channel length dependency of on/off ratio.

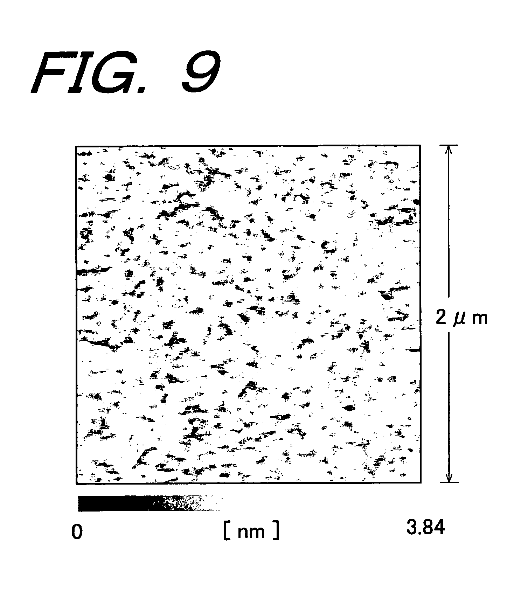

[Figure 9] Fig. 9 is an explanatory view showing the state where a polyparaxylylene film having the thickness of 10nm formed of "dix-C" (trademark), which is formed on the surface of an SiO₂ thermal oxide film, is observed by an atomic force microscope (AFM).

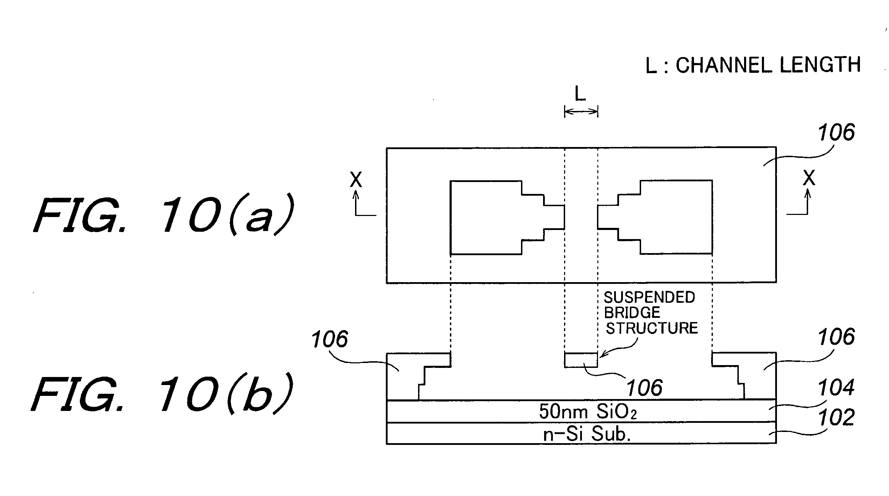

[Figure 10] Figs.10(a)(b) are explanatory views of an organic thin film transistor and the method for manufacturing the transistor, which uses a suspension bridge structure shown in Patent Application 2005-27034 (filing date: February 2, 2005) "Method for manufacturing top-contact type field-effect transistor and top-contact type field-effect transistor", where Fig.10(a) is a top surface explanatory view showing the state where a solid suspension bridge structure formed of a three-layered structure is formed by resist on an n-type Si substrate where the SiO₂ oxide film is formed, and Fig.10(b) is an end surface explanatory view when the transistor is cut off by X-X line of Fig.10(a).

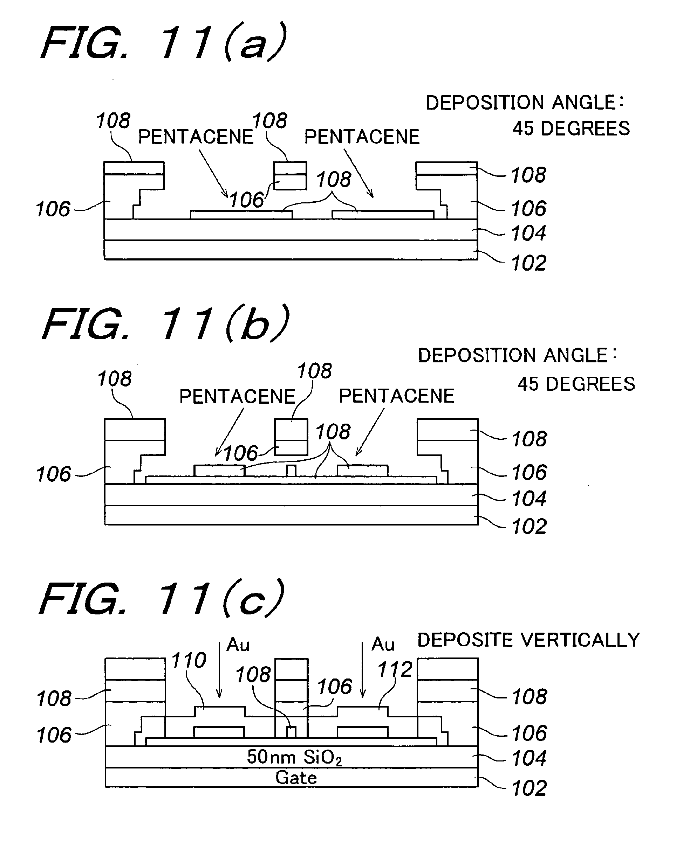

[Figure 11] Figs.11 (a) (b) (c) are explanatory views of an organic thin film transistor and the method for manufacturing the transistor, which uses a suspension bridge structure shown in Patent Application 2005-27034 (filing date: February 2, 2005) "Method for manufacturing top-contact type field-effect transistor and top-contact type field-effect transistor", where Fig.11(a) is the explanatory view of a first process, Fig.11(b) is the explanatory view of a second process, and Fig.11(c) is the explanatory view of a third process.

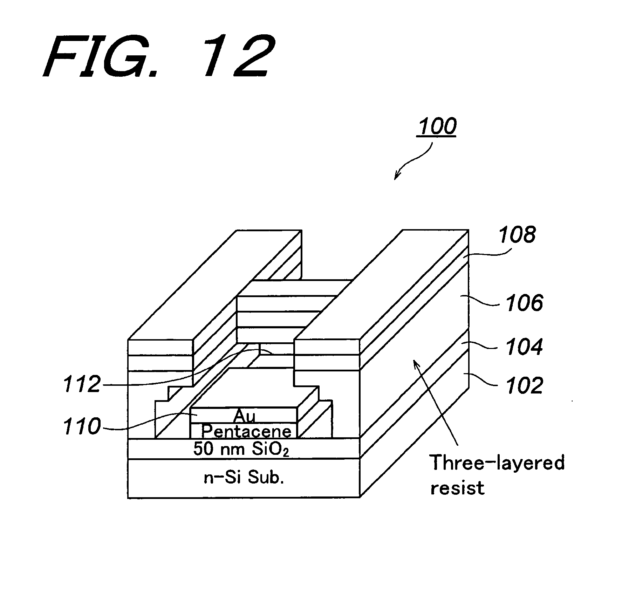

[Figure 12] Fig.12 is a conceptual constitution explanatory view of the organic thin film transistor using the suspension bridge structure.

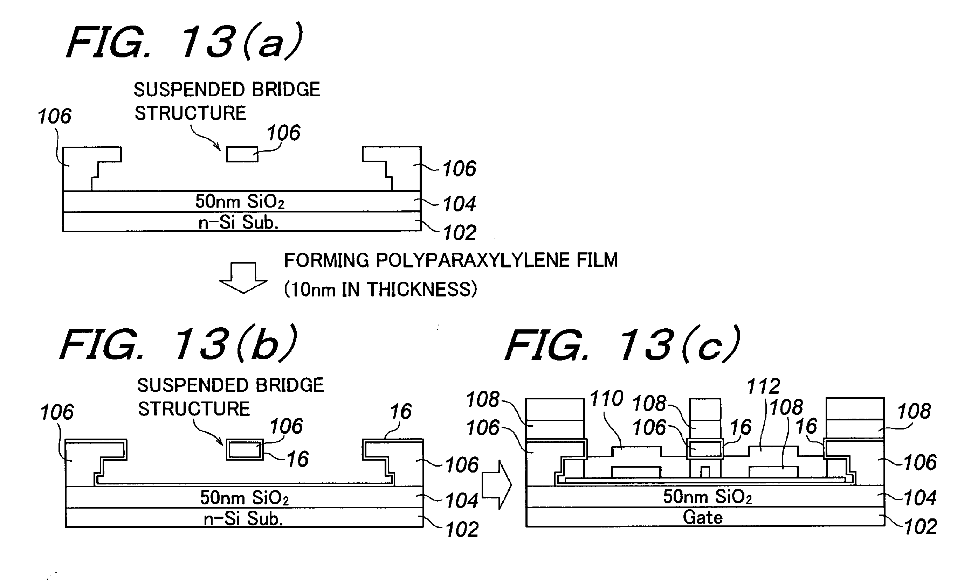

[Figure 13] Figs.13(a)(b)(c) are explanatory views showing a processing when applying the present invention to the organic thin film transistor using the suspended bridge structure, where Fig.13(a) is an explanatory view showing an n-type Si substrate where resist including the suspended bridge structure is formed on the SiO₂ oxide film, Fig.13(b) is an explanatory view showing the processing of forming the polyparaxylylene film, and Fig.13(c) is an explanatory view showing a transistor structure that is obtained by executing the first process to the third process shown in Figs.11(a) (b) (c).

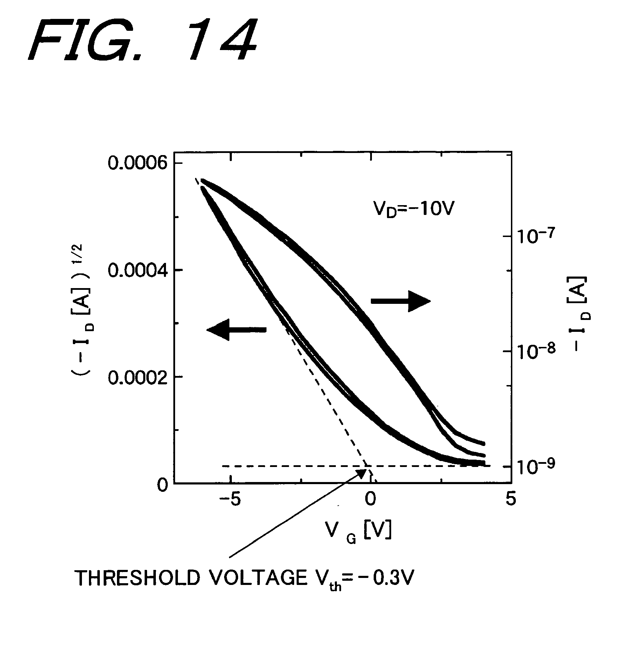

[Figure 14] Fig.14 is a graph showing an experiment result by the present inventor using the organic thin film transistor including the structure shown in Fig.11(c), and is a graph showing the measurement result of the transfer characteristics of the transistor including the structure shown in Fig.11(c).

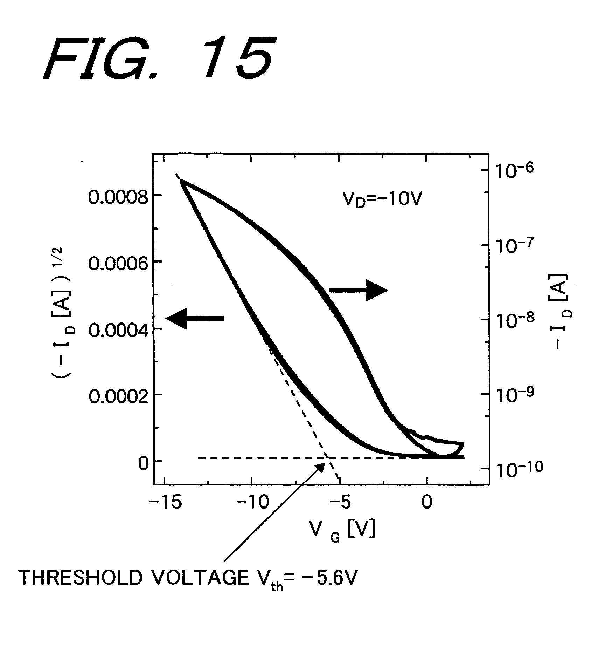

[Figure 15] Fig.15 is a graph showing an experiment result by the present inventor, which uses the organic thin film transistor including the structure by the present invention shown in Fig.13(c), and a graph showing the measurement result of the transfer characteristics of the transistor including the structure by the present invention shown in Fig.11(c).

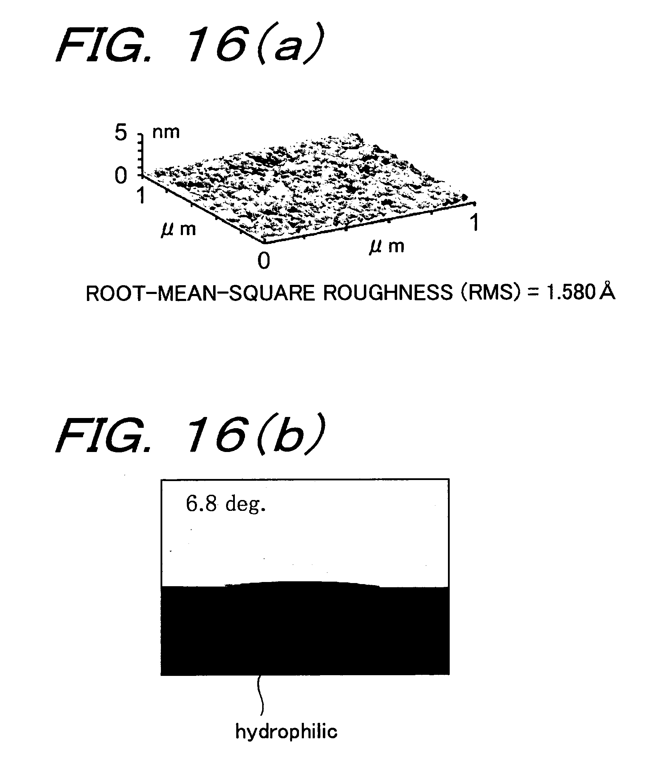

[Figure 16] Fig.16(a) is an explanatory view showing the state where the SiO₂ oxide film was observed by the atomic force microscope, Fig. 16 (b) is an explanatory view showing the state where one water droplet was dropped on the SiO₂ oxide film was observed by a microscope.

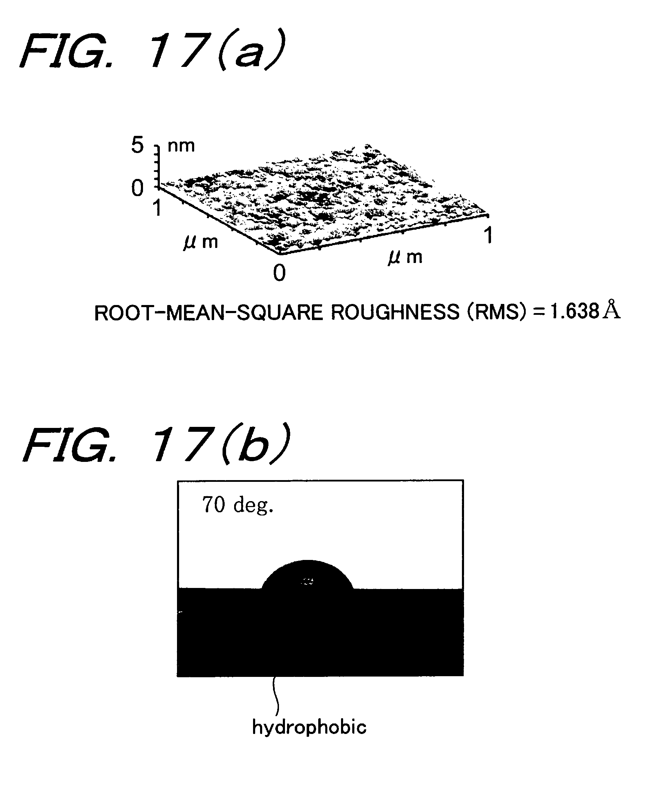

[Figure 17] Fig.17(a) is an explanatory view showing the state where HMDS is observed by the atomic force microscope, and Fig.17(b) is an explanatory view showing the state of observing the state where one water droplet was dropped on HMDS by the microscope.

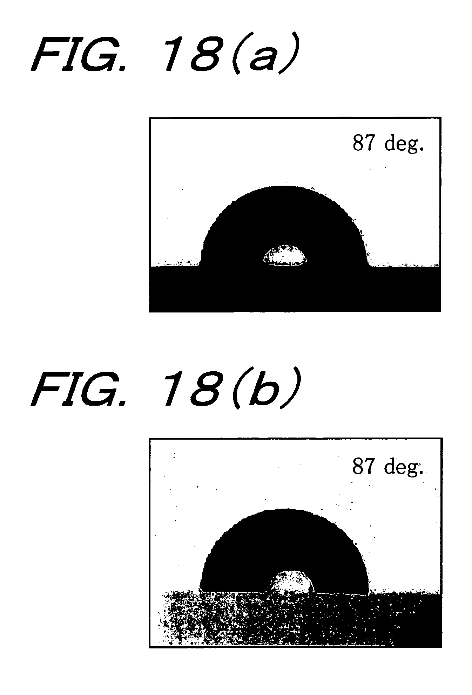

[Figure 18] Fig.18(a) is an explanatory view showing the state of observing the state where one water droplet was dropped on a "dix-C" (trademark) having the thickness of 10nm formed on the SiO₂ oxide film, and Fig.18(b) is an explanatory view showing the state of observing the state where one water droplet was dropped on the "dix-C" (trademark) having the thickness of 415nm formed on the SiO₂ oxide film.

### Description of Numerical Characters

- 10: Organic thin film transistor
- 12: Substrate
- 12a: Surface
- 14: Gate insulating layer
- 14a: Surface
- 16: Polyparaxylylene film
- 16a: Surface
- 18: Organic semiconductor layer
- 18a: Surface
- 20: Source electrode
- 22: Drain electrode
- 100: Organic thin film transistor
- 102: n-type Si substrate
- 104: SiO₂ oxide film
- 106: Resist
- 108: Pentacene film
- 110: Source electrode
- 112: Drain electrode

### Best Mode for Implementing the Invention

Hereinafter, description will be made in detail for an example of the embodiments of the organic thin film transistor and the method for surface modification of the gate insulating layer in the organic thin film transistor according to the present invention by referring to the attached drawings.

Fig.1 shows the constitution explanatory view of an example of the embodiment of the organic thin film transistor according to the present invention.
Specifically, an organic thin film transistor 10 according to an example of the present invention is constituted by having: a substrate 12 formed of semiconductor, which is a gate layer that functions as a substrate and a gate electrode; a gate insulating layer 14 formed of an insulative material, which is formed on one surface 12a of the substrate 12; a polyparaxylylene film 16 being a polyparaxylylene layer, which is formed on the surface 14a of the gate insulating layer 14 by depositing polyparaxylylene; an organic semiconductor layer 18 being an active layer formed of an organic material, which is formed on the surface 16a of the polyparaxylylene film 16; a source electrode 20 being a first electrode formed of a conductive material, which is formed on the surface 18a of the organic semiconductor layer 18; and a drain electrode 22 being a second electrode formed of a conductive material, which is formed on the surface 18a of the organic semiconductor layer 18.
Specifically, in the organic thin film transistor 10, the polyparaxylylene film 16 and the organic semiconductor layer 18 face and contact with each other, and the polyparaxylylene film 16 is arranged directly under the organic semiconductor layer 18.
It is to be noted that the polyparaxylylene film 16 and the organic semiconductor layer 18 should only be formed by deposition, for example.
Herein, as the substrate 12, an n-type Si substrate being an Si substrate doped with phosphorus can be used, for example, but the substrate is not limited to this, and an n-type semiconductor substrate or a p-type semiconductor substrate where various impurities are doped in various semiconductor materials can be used.
Further, as the gate insulating layer 14, an SiO₂ film being an insulative material can be used, for example, but the layer is not limited to this, and polymer film such as polyvinylphenol (PVP), polyvinylalcohol (PVA) and polystyrene (PS), for example, can be used instead of an oxide like SiO₂.
Moreover, the polyparaxylylene film 16 is formed as a continuous film, that is, a continuous film having no holes formed therein, and it is preferable to form the film by high-purity polyparaxylylene, for example, more particularly polyparaxylylene whose purity is 99% or higher. Further, although the film thickness of the polyparaxylylene film is not particularly limited, it is preferable that the thickness be about 5 to 200nm, more particularly about 5 to 100nm. Particularly, in the case where the surface of the polyparaxylylene film 16 can be formed homogeneously, the film thickness can be made as thin as about 5nm, for example.
It is to be noted that formation of a film whose surface is homogeneous is made possible by using high-purity polyparaxylylene.
Furthermore, as an organic material for forming the organic semiconductor layer 18, pentacene (Pentacene) can be used for example, but the material is not limited to this, and various organic materials such as copper phthalocyanine and thiophenes can be used, for example.
Further, the source electrode 20 and the drain electrode 22 can be formed by depositing metal being a conductive material which is Au, for example, by vapor deposition on the surface 18a of the organic semiconductor layer 18, for example, an Au electrode formed in this manner can be used as the source electrode 20 and the drain electrode 22. It is to be noted that a conductive material used as the source electrode 20 and the drain electrode 22 is not limited to Au, but Pt, Ag or the like can be used.

In the constitution above, in the above-described organic thin film transistor 10, the polyparaxylylene film 16 modifies the surface of the gate insulating layer 14 from hydrophilic to hydrophobic, and consequently, the transistor characteristics of the organic thin film transistor 10 could be significantly improved.

Next, description will be made for the experiment and its result by the present inventor, the organic thin film transistor by prior art and the organic thin film transistor by the present invention were fabricated in this experiment, and the transistor characteristics of the both transistors were compared.
First, description will be made for the manufacturing methods of the organic thin film transistor by prior art and the organic thin film transistor by the present invention used in the experiment. As the substrate 12, 6 pieces of n-type Si substrates where the SiO₂ thermal oxide film having the thickness of 200nm as the gate insulating layer 14 was formed on one surface were prepared and oxygen plasma cleaning was performed after solution cleaning by acetone and isopropyl alcohol was performed.
Regarding 3 pieces of n-type Si substrate out of the 6 pieces of the n-type Si substrate to which the above-described processing was performed, only on the surface of their SiO₂ thermal oxide film, a film formed of high-purity polychloroparaxylylene (poly chloro-para-xylylene) having the purity of 99% or higher was deposited as the polyparaxylylene film 16 by chemical vapor deposition (CVD) to so to be formed in the thickness of 10nm.
Meanwhile, in this experiment, "dix-C" (trademark) that is one of polyparaxylylene, which is generally called as "diX" (trademark) manufactured by Daisan Kasei Co., Ltd., was used as the high-purity polychloroparaxylylene having the purity of 99% or higher. It is to be noted that "diX" (trademark) has purity exceeding 99%.
Further, to deposit "dix-C" (trademark) on the surface of the SiO₂ thermal oxide film by chemical vapor deposition in this experiment, it was performed under reduced pressure by using an exclusive unit called "DACS-0" (trademark) manufactured by KISCO Ltd., which is used for coating "diX" (trademark) manufactured by Daisan Kasei Co., Ltd. This unit mainly consists of the 3 portions of a vaporizer, a pyrolizer and a deposition chamber, where the n-type Si substrate on which the SiO₂ thermal oxide film is formed is arranged in the deposition chamber, and powder of "dix-C" (trademark) being the coating material is arranged in the vaporizer. Then, after decompressing inside the unit, the temperature of the vaporizer is increased (120 to 180°C) to evaporate "dix-C"(trademark). When the evaporated gas is drawn by a vacuum pump to flow toward the deposition chamber side, and passes through the high-temperature (650 to 700°C) pyrolizer, the gas is thermally decomposed into monomer. Moreover, when the monomer contacts the SiO₂ thermal oxide film inside the deposition chamber of room temperature, it is cooled down and polymerized on the surface, and a high-molecular weight polyparaxylylene film is formed on the surface of the SiO₂ thermal oxide film.
Then, on the above-described 6 pieces of n-type Si substrates, pentacene film having the thickness of 30nm was vacuum-deposited as the organic semiconductor layer 18 through a metal mask.
Next, the metal mask was replaced, an Au film having the thickness of 50nm as the source electrode 20 and the drain electrode 22 was formed on the surface of the pentacene film vacuum-deposited as described above, and thus a three organic thin film transistor according to prior art (refer to Fig.2(a)) and three organic thin film transistors by the present invention (refer to Fig.2(b)) were fabricated.
Herein, the three organic thin film transistors by prior art (refer to Fig.2(a)) and the three organic thin film transistors by the present invention (refer to Fig.2(b)) were severally formed such that the channel length L becomes 200 µm (refer to Fig.3(a)), 100µm (refer to Fig.3(b)) and 50µ m(Fig.3(c)) as shown in Figs.3(a) (b) (c) in arrow A of Fig.2 (a) or in arrow B of Fig.2(b). It is to be noted that a channel width W was set to 1mm for all cases.
Therefore, according to the above-described manufacturing method, the three organic thin film transistor by prior art having the channel length L of 200 µm, 100 µm or 50 µm, and similarly, the three organic thin film transistor by the present invention having the channel length L of 200µm, 100µm or 50 µm were obtained.
It is to be noted that the degree of vacuum during deposition is 2×10⁻⁴Pa for all cases in the above-described manufacturing method.

First, the output characteristics and the transfer characteristics of the transistor were measured by using the organic thin film transistor by prior art having the channel length L of 50µm (refer to Fig.2(a) and Fig.3(c)).
Herein, Fig.4(a) is the graph showing the measurement result of the output characteristics of the transistor, and Fig.4(b) is the graph showing the measurement result of the transfer characteristics of the transistor. It is to be noted that I_{D} denotes a drain current, V_{D} denotes a drain voltage, V_{G} denotes a gate voltage, Vₜₕ denotes a threshold voltage in Figs.2 and 3, and the same applies to each graph to be described below.
The measurement result took the threshold voltage Vₜₕ of +10V and the threshold voltage Vₜₕ of a positive value as shown in Fig.4(b). Specifically, a current flows even if the gate voltage is not applied, which means that Off is not taken when the gate voltage was zero.
It is to be noted that the mobility of transistor is 0.069cm²/Vs and the on/off ratio is 6.4×10³.
Further, in the organic thin film transistor by prior art having the channel length L of 50 µm, as shown in the graph of Fig.5 where 10 times of measurement were recorded, measurement values shifted from left to right on the graph as measurement was repeated, and operation was unstable due to the change of the measurement value changed as measurement was repeated. It is to be noted that 45 seconds were required for one measurement.

On the other hand, Figs.6(a)(b) show the measurement result of the output characteristics and the transfer characteristics of the transistor by using the organic thin film transistor by the present invention having the channel length L of 50µm (refer to Fig.2(b) and Fig.3(c)).
Herein, Fig.6(a) is the graph showing the measurement result of the output characteristics of the transistor and Fig.6(b) is the graph showing the measurement result of the transfer characteristics of the transistor, where the measurement result took the threshold voltage Vₜₕ of -12V and the threshold voltage Vₜₕ of a negative value as shown in Fig.6 (b). Specifically, a current did not flow unless the gate voltage was applied, and Off was taken when the gate voltage was zero.
It is to be noted that the mobility of transistor is 0.17cm²/Vs and the on/off ratio is 8.9×10⁴.
Further, in the organic thin film transistor by the present invention having the channel length L of 50 µm, as shown in the graph of Fig.7 where 10 times of measurement were recorded, measurement values are substantially overlapped with each other even if measurement was repeated, the measurement values scarcely changed even if measurement was repeated, and showed stable operation. It is to be noted that 45 seconds were required for one measurement.

Next, by using the organic thin film transistor by prior art and the organic thin film transistor by the present invention each having the channel length L of 50µm, 100µm and 200µm, each channel length dependency for the threshold voltage Vth, the mobility and the on/off ratio was measured.
Figs.8(a)(b)(c) show the measurement result, where Fig.8(a) is the graph showing the channel length dependency of the threshold voltage Vₜₕ, Fig.8(b) is the graph showing the channel length dependency of the mobility, Fig. 8 (c) is the graph showing the channel length dependency of the on/off ratio.
As shown in the graphs of Figs. 8 (a) (b) (c), in all channel lengths having the channel length L of 50µm, 100µm and 200 µm, the organic thin film transistor by the present invention shows significant improvement comparing to the organic thin film transistor by prior art in the threshold voltage Vₜₕ, the mobility and the on/off ratio.

Herein, Fig.9 shows the explanatory view of the state where the polyparaxylylene film having the thickness of 10nm formed of "dix-C" (trademark), which was formed on the surface of the SiO₂ thermal oxide film, was observed by the atomic force microscope (AFM).
The polyparaxylylene film having the thickness of 10nm formed of "dix-C" (trademark) has:
Average roughness (Ra)=0.4847nm;
Maximum vertical interval (P-V)=4.76nm; and
Root-mean-square roughness (RMS)=0.6093nm and includes a relatively flat surface shape.
Meanwhile, for reference, the SiO₂ thermal oxide film formed on the n-type Si substrate had Root-mean-square roughness (RMS)=0.158nm.

Further, since the polyparaxylylene film has characteristics that it thoroughly grows around the surface of an object, the present invention can be applied to a transistor having the shape described below, which is proposed by the present applicant.
Specifically, the present applicant proposes the organic thin film transistor using the suspended bridge structure and the method for manufacturing the transistor that will be described referring to Fig.10 to Fig.12 as Patent Application 2005-27034 (filing date: February 2, 2005) "Method for manufacturing top-contact type field-effect transistor and top-contact type field-effect transistor".
To fabricate the organic thin film transistor using the suspension bridge structure, firstly, a solid suspended bridge structure formed of a three-layered structure by resist 106 is formed on an n-type Si substrate 102 (corresponding to the substrate 12) where an SiO₂ oxide film 104 (corresponding to the gate insulating layer 14) having the thickness of 50nm is formed on one surface as the gate insulating layer by using electron beam lithography technology (refer to Figs. 10 (a) (b)).
Then, to the n-type Si substrate 102 where the resist 106 including the suspended bridge structure was formed on the SiO₂ oxide film 104, by performing a first process of depositing a pentacene film 108 (corresponding to the organic semiconductor layer 18) at the deposition angle of 45 degrees to a vertical direction (refer to Fig.11(a)), a second process of depositing the pentacene film 108 (corresponding to the organic semiconductor layer 18) at the deposition angle of 45 degrees to the vertical direction which is symmetrical to the deposition angle in the first process (refer to Fig.11(b)), and a third process of depositing a metal material, which becomes a source electrode 110 (corresponding to the source electrode 20) and a drain electrode 112 (corresponding to the drain electrode 22), from the vertical direction (refer to Fig.11(c)), an organic thin film transistor 100 using the suspended bridge structure as conceptually shown in Fig.12 can be formed.
It is to be noted that a channel is formed under the suspended bridge structure in such an organic thin film transistor using the suspended bridge structure.

Herein, in applying the present invention to the above-described organic thin film transistor using the suspended bridge structure, as shown in Figs.13(a) (b) (c), to the n-type Si substrate 102 where the resist 106 including the suspended bridge structure is formed on the SiO₂ oxide film 104 having the thickness of 50nm (refer to Fig.13(a)), "dix-C" (trademark) being the high-purity polychloroparaxylylene exceeding the purity of 99% is formed as the polyparaxylylene film 16 in the thickness of 10nm by chemical vapor deposition (refer to Fig.13(b)). Since the polyparaxylylene film has characteristics that it thoroughly grows around the surface of an object, the film also thoroughly grows under the suspended bridge structure.
Then, the first process to the third process shown in Figs.11(a)(b)(c) described above are executed to form the transistor structure (refer to Fig.13(c)).

Next, the transfer characteristics of the transistor was measured by using the organic thin film transistor including the structure shown in Fig.11(c) and the organic thin film transistor including the structure by the present invention shown in Fig.13(c). It is to be noted that the channel length of the organic thin film transistor including the structure shown in Fig.11(c) was 0.4µm, and its channel width was 3µ m. On the other hand, the channel length of the organic thin film transistor including the structure by the present invention shown in Fig. 13 (c) is 0.35µm, its channel width is 2.9µm, and the thickness of "dix-C" (trademark) being the polyparaxylylene film 16 is 10nm as described above.
Fig.14 is the graph showing the measurement result of the transfer characteristics of the organic thin film transistor including the structure shown in Fig.11(c), where the threshold voltage Vₜₕ was -0.3V, the mobility of transistor was 0.029cm²/Vs, and the on/off ratio was 2.5×10².
On the other hand, Fig.15 is the graph showing the measurement result of the transfer characteristics of the organic thin film transistor including the structure by the present invention shown in Fig.13(c), where the threshold voltage Vₜₕ is -5.6V, the mobility of transistor is 0.044cm²/Vs, and the on/off ratio is 4.8×10³, and the characteristics have been improved comparing to organic thin film transistor including the structure shown in Fig.11(c).

Herein, description will be made for a measurement result by a contact angle measurement method for evaluating water contact angle where the water contact angle of "dix-C" (trademark) the polyparaxylylene film 16 was measured.
It is to be noted that the water contact angle measurement method is a measurement method where one water droplet is dropped on a substrate and a contact angle of water edge with the substrate is measured.
Herein, for comparison, measurement was also performed for the SiO₂ oxide film formed on the Si substrate and HMDS coated on the surface of the SiO₂ oxide film that was formed on the Si substrate by spin coating.
Fig.16 (a) shows the explanatory view showing the state where the SiO₂ oxide film was observed by the atomic force microscope, and Fig.16 (b) shows the explanatory view showing the state of observing the state where one water droplet was dropped on the SiO₂ oxide film by the microscope.
The root-mean-square roughness (RMS) of the SiO₂ film was 0.1580nm, and the water contact angle was 6.8 degrees.
Further, Fig.17(a) shows the explanatory view showing the state where the HMDS was observed by the atomic force microscope, and Fig.17(b) shows the explanatory view showing the state of observing the state where the state where one water droplet was dropped on the HMDS by the microscope.
The root-mean-square roughness (RMS) of the HMDS was 0.1638nm, and the water contact angle was 70 degrees.
Then, Fig.18(a) shows the explanatory view showing the state of observing the state where one water droplet was dropped on "dix-C" (trademark) having the thickness of 10nm, which was formed on the SiO₂ oxide film, by the microscope, and Fig.18(b) shows the explanatory view showing the state of observing the state where one water droplet was dropped on "dix-C" (trademark) having the thickness of 415nm, which was formed on the SiO₂ oxide film, by the microscope.
Regarding "dix-C" (trademark), the water contact angle was 87 degrees for the both cases of film thickness 10nm and 415nm. Specifically, the water contact angle does not change even if the film thickness of "dix-C" (trademark) is made thin or thick.
Herein, although the water contact angle needs to be larger in order to modify the surface of the gate insulating layer 14 into hydrophobic, the water contact angle does not change even if the film thickness of "dix-C" (trademark) is made thin or thick, and the water contact angle of 85 degrees or larger is obtained even with the film thickness of about 5nm if the polyparaxylylene film 16 is a continuous film, and the surface of the gate insulating layer 14 is modified into hydrophobic.

It is to be noted that the above-described embodiment may be modified as described in (1) to (3) below.
(1) In the above-described embodiment, polychloroparaxylylene whose purity exceeds 99% was shown as an example of polyparaxylylene, it goes out without saying that the material is not limited to this, and polyparaxylylene derivative using 4-amino (2,2) paracyclophane, 4-aminomethyl (2,2) paracyclophane, tetrachloro (2,2) paracyclophane, 1,1,9,9-tetrafluoro (2,2) paracyclophane or the like as an initial material can be used.
(2) In the above-described embodiment, specific material names and thickness have been shown regarding the substrate 12, the gate insulating layer 14, the organic semiconductor layer 18, the source electrode 20 and the drain electrode 22, but it goes without saying that the materials and the thickness are merely examples, and it is a matter of course that materials and the thickness may be appropriately selected corresponding to design conditions or the like.
(3) The modification examples shown in the above-described embodiment and above-described (1) to (2) may be appropriately combined.

### Industrial Applicability

The present invention can be used in manufacturing a flexible display, a fine organic electronic device, a nano-bio device and the like which are used in electronic equipment, medical equipment and the like.

## Claims

1. An organic thin film transistor where an organic semiconductor layer is stacked on a gate insulating layer and an electrode is formed on said organic semiconductor layer, wherein
a polyparaxylylene layer formed of continuous polyparaxylylene film is formed on the surface of said gate insulating layer, between the gate insulating layer and the organic semiconductor layer, so as to face and contact said organic semiconductor layer.

2. The organic thin film transistor according to Claim 1, wherein
said polyparaxylylene film is a continuous film whose film thickness shows the angle of 85 degrees or more by contact angle measurement of water.

3. The organic thin film transistor according to any one of Claims 1 and 2, wherein
said polyparaxylylene has the purity of 99% or higher.

4. The organic thin film transistor according to any one of Claims 1, 2 and 3, wherein
the thickness of said polyparaxylylene film is 5 to 200nm.

5. The organic thin film transistor according to any one of Claims 1, 2, 3 and 4 wherein
said polyparaxylylene is polychloroparaxylylene.

6. A method for surface modification of a gate insulating layer in an organic thin film transistor where an organic semiconductor layer is stacked on a gate insulating layer and an electrode is formed on said organic semiconductor layer, wherein
a polyparaxylylene film is deposited as a continuous film having a predetermined thickness on the surface of the gate insulating layer by chemical vapor deposition.

7. The method for surface modification of a gate insulating layer in an organic thin film transistor according to Claim 6, wherein
the film thickness of said continuous film shows the angle of 85 degrees or more by contact angle evaluation of water.

8. The method for surface modification of a gate insulating layer in an organic thin film transistor according to any one of Claims 6 and 7, wherein
said polyparaxylylene has the purity of 99% or higher.

9. The method for surface modification of a gate insulating layer in an organic thin film transistor according to any one of Claims 6, 7 and 8, wherein
the film thickness of said continuous film is 5 to 200nm.

10. The method for surface modification of a gate insulating layer in an organic thin film transistor according to any one of Claims 6, 7, 8 and 9, wherein
said polyparaxylylene is polychloroparaxylylene.
